(19) **Europäisches Patentamt / European Patent Office / Office européen des brevets**

(11) **EP 2 667 214 B1**

(12) **FASCICULE DE BREVET EUROPEEN**

(45) Date de publication et mention
de la délivrance du brevet:
**10.02.2016 Bulletin 2016/06**

(51) Int Cl.:
***G01R 33/09*** *(2006.01)*   ***G01R 33/00*** *(2006.01)*

(21) Numéro de dépôt: **13168433.4**

(22) Date de dépôt: **20.05.2013**

(54) **Procédé d ajustement de la résistance d' un capteur**

Verfahren zur Anpassung des Widerstandes eines Sensors

Method for adjusting the resistance of a sensor

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.05.2012 FR 1254619**

(43) Date de publication de la demande:
**27.11.2013 Bulletin 2013/48**

(73) Titulaire: **NTN-SNR Roulements
74000 Annecy (FR)**

(72) Inventeurs:
 • **Duret, Christophe
74600 Quintal (FR)**
 • **Peterschmitt, Cyril
74000 Annecy (FR)**

(74) Mandataire: **Sayettat, Julien Christian
STRATO-IP
18, rue Soleillet
75020 Paris (FR)**

(56) Documents cités:
**US-A1- 2005 237 789**

**EP 2 667 214 B1**

**Description**

L'invention concerne un procédé d'ajustement de la résistance d'un capteur comprenant au moins un bloc de mesure présentant un circuit de mesure formé entre deux bornes principales, ledit circuit de mesure comprenant un montage en série de plusieurs éléments résistifs.

Dans une application particulière, chacun des éléments résistifs comprend deux couches conductrices entre lesquelles une couche isolante est disposée pour former une succession de jonctions tunnel le long du circuit de mesure.

Ainsi, les capteurs peuvent mesurer un champ magnétique en exploitant la variation de la résistance électrique d'éléments magnétorésistifs à effet tunnel (TMR en anglais pour Tunnel MagnetoResistance) en fonction dudit champ magnétique. En particulier, les couches conductrices forment respectivement une couche magnétique sensible au champ à mesurer et une couche magnétique de référence, la résistance électrique entre les couches conductrices étant fonction de l'orientation relative de l'aimantation de chacune desdites couches.

Toutefois, la résistance électrique des éléments résistifs est fonction de l'épaisseur de la couche isolante, typiquement entre 1 et 2 nm, qui est très difficilement contrôlable alors que son influence sur la résistance est exponentielle.

Par ailleurs, la couche isolante est très sensible aux décharges électrostatiques puisqu'une différence de potentiel de quelques Volts entre les couches conductrices peut provoquer la rupture irréversible de la continuité de la couche isolante, rendant la jonction tunnel totalement passante.

Il en résulte que la résistance d'un bloc de mesure comprenant une succession de plusieurs éléments résistifs est difficilement reproductible, et ce tant relativement à la valeur de cette résistance qu'à la répartition spatiale de celle-ci le long du circuit de mesure.

Ce problème est d'autant plus préjudiciable lorsque le capteur comprend plusieurs blocs de mesure, par exemple montés en pont de Wheatstone ou en boucle de courant, qui doivent présenter des valeurs de résistances voisines en l'absence de signal à mesurer, sauf à générer un offset qui peut limiter la résolution de la mesure, voire empêcher toute mesure si sa valeur est trop importante.

En outre, la répartition spatiale des éléments résistifs s'avère critique dans le cas d'une mesure d'un signal périodique puisque lesdits éléments permettent de reconstruire ledit signal par échantillonnage spatial.

L'invention vise à perfectionner l'art antérieur en proposant notamment un procédé d'ajustement de la résistance d'un capteur dont la mise en oeuvre permet de régler la valeur et/ou la répartition spatiale de la résistance de chacun des blocs de mesure.

A cet effet, l'invention propose un procédé d'ajustement de la résistance d'un capteur comprenant au moins un bloc de mesure présentant un circuit de mesure formé entre deux bornes principales, ledit circuit de mesure comprenant un montage en série de plusieurs éléments résistifs, ledit procédé prévoyant :

- de sélectionner un groupe résistif comprenant au moins un élément résistif du circuit de mesure ;
- de connecter au moins une borne auxiliaire audit circuit de mesure, ladite borne auxiliaire étant disposée de sorte à former avec une autre borne un circuit auxiliaire comprenant le groupe résistif ;
- d'appliquer une tension aux bornes du circuit auxiliaire, ladite tension étant contrôlée de sorte à induire le claquage du groupe résistif afin d'ajuster la résistance du circuit de mesure sans ledit groupe résistif.

D'autres particularités et avantages de l'invention apparaîtront dans la description qui suit, faite en référence aux figures jointes, dans lesquelles :

- la figure 1 représente un circuit de mesure selon un mode de réalisation de l'invention ;
- la figure 2 représente deux blocs de mesure montés en série avec les barycentres des éléments résistifs de leur circuit de mesure respectif espacés d'une distance λ ;
- les figures 2a à 2d sont des représentations analogues à la figure 2 dans lesquelles la répartition spatiale de la résistance de chacun des circuits de mesure est ajustée pour faire varier la distance entre les barycentres ;
- les figures 3a et 3b représentent un bloc de mesure selon respectivement une variante d'un mode de réalisation de l'invention.

En relation avec ces figures, on décrit un procédé d'ajustement de la résistance d'un capteur comprenant au moins un bloc de mesure présentant un circuit de mesure formé entre deux bornes principales 1 a, 1 b.

Dans des exemples de réalisation, le capteur comprend plusieurs blocs de mesure, notamment montés en pont de Wheatstone ou en boucle de courant, afin de mesurer un signal périodique, comme notamment décrit dans le document FR-2 869 980 en relation avec un signal de déformation ou dans le document FR-2 792 403 en relation avec un signal magnétique.

Le circuit de mesure comprend un montage en série de plusieurs, par exemple entre 2 et 24, éléments résistifs 2 dont la résistance varie en fonction du signal à mesurer. Dans les modes de réalisation représentés, les éléments résistifs 2 comprennent chacun deux couches conductrices 3, 4 entre lesquelles une couche isolante 5 est disposée pour former une succession de jonctions tunnel le long du circuit de mesure.

En particulier, comme décrit dans le document WO-2004/083881, un capteur magnétique peut utiliser des éléments magnétorésistifs TMR comprenant chacun une couche magnétique 3 sensible au champ à mesurer et une couche magnétique 4 de référence, la résistance électrique entre les couches 3, 4 étant fonction de l'orientation relative de l'aimantation de chacune desdites couches. Le procédé d'ajustement prévoit de sélectionner un groupe résistif comprenant au moins un élément résistif 2 du circuit de mesure et de connecter au moins une borne auxiliaire 6 audit circuit de mesure, ladite borne auxiliaire étant disposée de sorte à former avec une autre borne 1a, 1b, 6 un circuit auxiliaire comprenant le groupe résistif. En particulier, en fonction du groupe résistif sélectionné, le circuit auxiliaire peut être formé entre une borne principale 1a, 1 b et une borne auxiliaire 6, ou entre deux bornes auxiliaires 6.

Ensuite, le procédé prévoit d'appliquer une tension aux bornes du circuit auxiliaire, ladite tension étant contrôlée de sorte à induire le claquage du groupe résistifs afin d'ajuster la résistance du circuit de mesure sans ledit groupe résistif. En effet, le claquage d'un élément résistif 2 rend sa résistance électrique nulle, ledit élément devenant alors inopérant dans le circuit de mesure. En outre, la formation du circuit auxiliaire permet de ne claquer que le groupe résistif, les autres éléments résistifs 2 n'étant pas compris dans le circuit auxiliaire et donc non soumis à la tension de claquage.

En particulier, avec des éléments TMR, une tension contrôlée de quelques Volts provoque la rupture irréversible de la continuité des couches isolantes 5 rendant les jonctions tunnel du circuit auxiliaire totalement passantes.

La mise en oeuvre du procédé permet donc, pour un circuit de mesure donné, d'ajuster sa résistance en faisant claquer sélectivement des groupes résistifs. En particulier, on peut sélectionner plusieurs groupes résistifs permettant chacun un ajustement de la résistance, plusieurs bornes auxiliaires 6 étant connectées pour former un circuit auxiliaire pour chacun desdits groupes. Ainsi, en fonction de l'ajustement souhaité, on peut choisir le circuit auxiliaire aux bornes duquel la tension de claquage est appliquée.

La sélection d'un groupe résistif peut être réalisée en fonction de la valeur de sa résistance afin d'ajuster la valeur de la résistance du circuit de mesure. Pour ce faire, le groupe résistif peut être sélectionné en fonction du nombre d'éléments résistifs 2 qu'il contient afin d'ajuster la valeur de sa résistance qui sera déduite de celle du circuit de mesure.

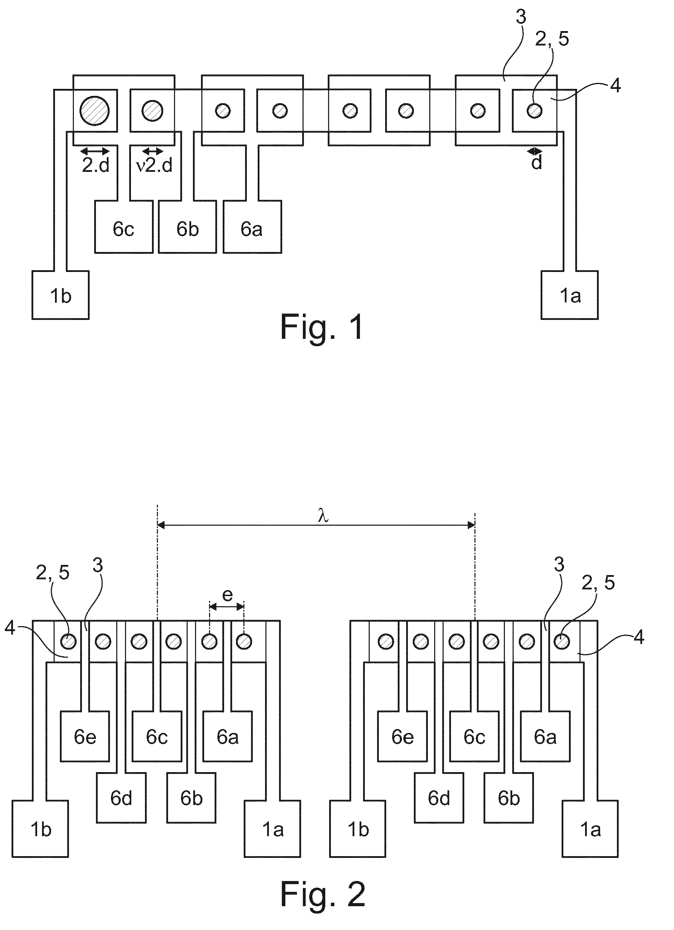

En relation avec la figure 1, on décrit ci-dessous une réalisation dans laquelle un circuit de mesure comprend des éléments résistifs 2 dont la résistance est différente. Ainsi, un groupe résistif peut être sélectionné en fonction du ou des élément(s) résistif(s) 2 qu'il contient afin d'ajuster la valeur de sa résistance.

En particulier, la valeur de la résistance d'un élément résistif 2 varie selon la loi :

$$R = \frac{RA}{S}$$

RA étant la résistance surfacique de l'élément résistif 2 (en $\Omega.\mu m^2$) ; et
S étant la surface de l'élément résistif 2 (en $\mu m^2$).

Sur la figure 1, huit éléments résistifs 2 présentant chacun une surface circulaire sont montés en série dans un circuit de mesure formé entre deux bornes principales 1a, 1b, le diamètre des six premiers éléments 2 étant égal à d, le diamètre du septième élément 2 étant égal à $\sqrt{2}\,d$ et le diamètre du huitième élément 2 étant égal à 2d.

En outre, trois bornes auxiliaires 6a-6c sont connectées pour former notamment les circuits auxiliaires suivants :

(1) entre les première 6a et deuxième 6b bornes auxiliaires comprenant le sixième élément résistif 2, de résistance R ;
(2) entre les deuxième 6b et troisième 6c bornes auxiliaires comprenant le septième élément résistif 2, de résistance R/2 ;
(3) entre la troisième borne auxiliaire 6c et la deuxième borne principale 1 b comprenant le huitième élément résistif 2, de résistance R/4.

Le tableau ci-dessous synthétise la résistance du circuit de mesure en fonction du circuit auxiliaire auquel la tension de claquage a été appliquée, 0 signifiant que la tension de claquage a été appliquée et 1 qu'elle ne l'a pas été.

| Circuit (1) | Circuit (2) | Circuit (3) | Résistance du circuit de mesure |
|---|---|---|---|
| 0 | 0 | 0 | 5R + 0.R/4 |
| 0 | 0 | 1 | 5R + 1.R/4 |

(suite)

| Circuit (1) | Circuit (2) | Circuit (3) | Résistance du circuit de mesure |
|:---:|:---:|:---:|:---:|
| 0 | 1 | 0 | 5R + 2.R/4 |
| 0 | 1 | 1 | 5R + 3.R/4 |
| 1 | 0 | 0 | 5R + 4.R/4 |
| 1 | 0 | 1 | 5R + 5.R/4 |
| 1 | 1 | 0 | 5R + 6.R/4 |
| 1 | 1 | 1 | 5R + 7.R/4 |

Cette réalisation permet donc d'ajuster la résistance du circuit de mesure par pas de R/4. Le principe est évidemment le même avec plus de trois éléments résistifs 2 différents, le pas étant alors plus fin et le réglage de la résistance plus précis. En outre, si la résistance des éléments 2 à claquer est quelconque, on peut également ajuster la résistance du circuit de mesure mais avec un pas de réglage irrégulier.

La sélection d'un groupe résistif peut être réalisée en fonction de sa position dans le circuit de mesure afin d'ajuster la répartition spatiale des résistances dans ledit circuit.

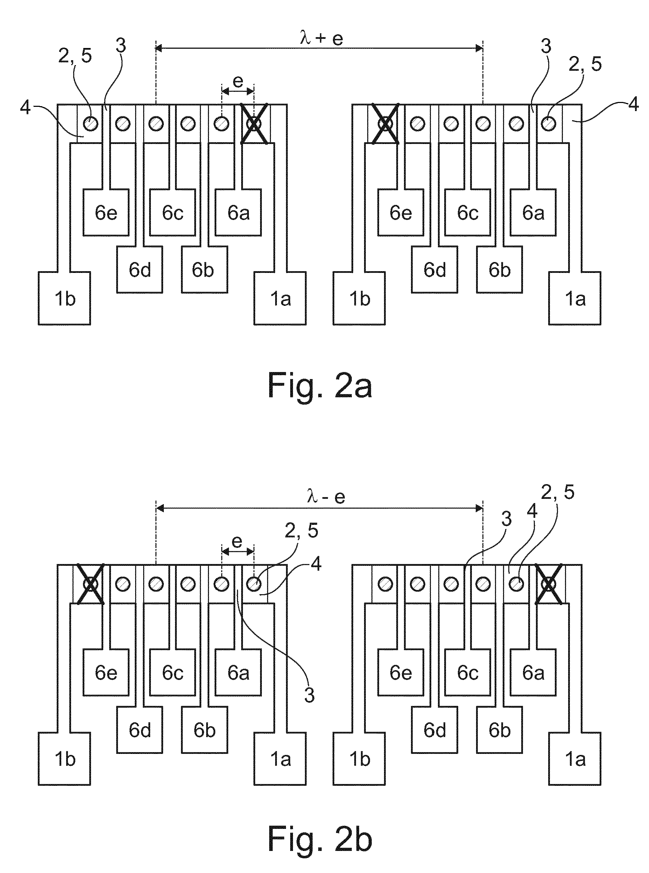

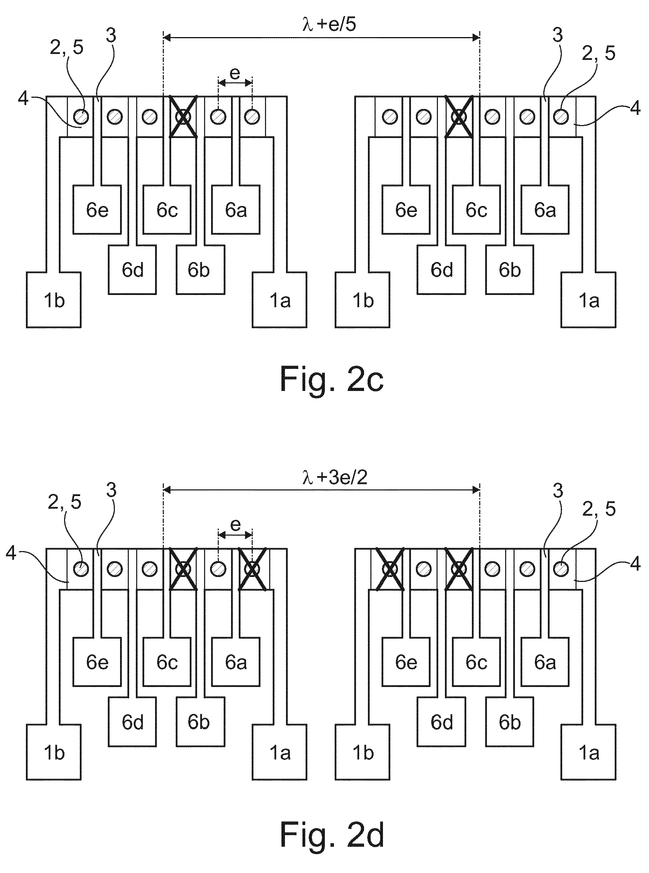

En relation avec les figures 2, on décrit un capteur comprenant au moins deux blocs de mesure avec les barycentres des éléments résistifs 2 de leur circuit de mesure respectif espacés d'une distance λ. De façon connue, par exemple du document FR-2 790 827, ce type de capteur peut être utilisé en face d'un codeur multipolaire pour détecter sa position et sa direction. Toutefois, pour que le signal de sortie ne soit pas entaché d'erreur, il convient d'ajuster la distance λ à la longueur polaire du codeur.

En relation avec les figures 2a à 2d, on décrit ci-dessous la mise en oeuvre du procédé pour ajuster la répartition spatiale de la résistance de chacun des circuits de mesure afin de faire varier la distance λ. Ainsi, la mise en oeuvre du procédé permet, avec un même capteur, de le configurer pour différentes applications nécessitant une longueur polaire spécifique du codeur.

Sur ces figures, une borne auxiliaire 6 est connectée entre chaque élément résistif 2 afin de pouvoir claquer sélectivement chacun desdits éléments de façon indépendante. En variante, un groupe résistif peut comprendre plusieurs éléments résistifs 2 à claquer conjointement pour faire varier la distance λ.

Sur la figure 2a, l'élément résistif 2 intérieur de chacun des circuits de mesure est claqué pour ajuster l'espacement des barycentres à une distance de λ + e, e étant l'espacement entre deux éléments résistifs 2 adjacents. De même, en claquant successivement les éléments résistifs 2 adjacents dans chacun des circuits de mesure, on obtient une distance entre les barycentres de λ + 2e, λ + 3e, λ + 4e.

Sur la figure 2b, l'élément résistif 2 extérieur de chacun des circuits de mesure est claqué pour ajuster l'espacement des barycentres à une distance de λ - e. De même, en claquant successivement les éléments résistifs 2 adjacents dans chacun des circuits de mesure, on obtient une distance entre les barycentres de λ - 2e, λ - 3e, λ - 4e.

Sur la figure 2c, un élément résistif 2 de chacun des circuits de mesure est claqué pour ajuster l'espacement des barycentres à une distance de λ + e/5. Sur la figure 2d, l'élément résistif 2 intérieur de chacun des circuits de mesure est également claqué pour obtenir une distance de λ + 3e/2.

Une borne auxiliaire 6 peut être connectée au circuit de mesure par l'intermédiaire d'un ensemble auxiliaire 7 d'éléments résistifs 2 montés en série. Grâce à la petite taille des jonctions tunnel (quelques microns de dimension caractéristique), l'ensemble auxiliaire 7 peut comprendre un grand nombre d'éléments résistifs 2 sans trop augmenter la surface du bloc de mesure.

En particulier, l'ensemble auxiliaire 7 assure une fonction de protection du circuit de mesure vis-à-vis des décharges électrostatiques qui pourraient endommager de façon non souhaitée les jonctions tunnel lors du montage du capteur. La tension parasite appliquée entre deux bornes principales 1a, 1b ou auxiliaires 6 est ainsi divisée par le nombre de jonctions comprises entre ces bornes. Ensuite, le circuit auxiliaire comprenant l'ensemble auxiliaire 7, les éléments résistifs 2 dudit ensemble sont claqués pour ne pas perturber le fonctionnement du circuit de mesure.

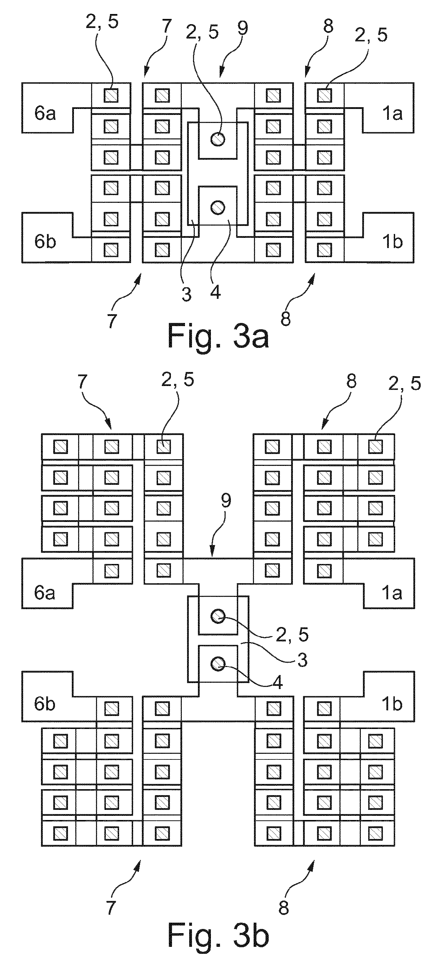

En relation avec les figures 3, le circuit de mesure comprend deux ensembles annexes 8 d'éléments résistifs 2 qui sont disposés de part et d'autre d'un ensemble principal 9 d'au moins un élément résistif 2, une borne auxiliaire 6a, 6b étant connectée de chaque côté dudit ensemble principal pour former avec une borne principale 1a, 1b un circuit auxiliaire comprenant un ensemble auxiliaire 7 et un ensemble annexe 8. Ainsi, l'ensemble principal 9 est protégé contre les décharges électrostatiques par l'intermédiaire des quatre ensembles 7,8.

Sur la figure 3a, les ensembles auxiliaire 7 et annexe 8 comprennent chacun six éléments résistifs 2 qui permettent de multiplier par 7 la résistance aux décharges électrostatiques de l'ensemble principal 9 comprenant deux jonctions tunnel. Sur la figure 3b, quatorze éléments résistifs 2 sont utilisés dans chaque ensemble 7, 8.

**Revendications**

1. Procédé d'ajustement de la résistance d'un capteur comprenant au moins un bloc de mesure présentant un circuit de mesure formé entre deux bornes principales (1a, 1 b), ledit circuit de mesure comprenant un montage en série de plusieurs éléments résistifs (2), ledit procédé prévoyant :

   - de sélectionner un groupe résistif comprenant au moins un élément résistif (2) du circuit de mesure ;
   - de connecter au moins une borne auxiliaire (6) audit circuit de mesure, ladite borne auxiliaire étant disposée de sorte à former avec une autre borne (1 a, 1 b, 6) un circuit auxiliaire comprenant le groupe résistif ;
   - d'appliquer une tension aux bornes du circuit auxiliaire, ladite tension étant contrôlée de sorte à induire le claquage du groupe résistif afin d'ajuster la résistance du circuit de mesure sans ledit groupe résistif,

   **caractérisé en ce que** chacun des éléments résistifs comprend deux couches conductrices entre lesquelles une couche isolante est disposée pour former une succession de jonctions tunnel le long du circuit de mesure.

2. Procédé d'ajustement selon la revendication 1, **caractérisé en ce qu'**il prévoit de sélectionner plusieurs groupes résistifs permettant chacun un ajustement de la résistance, de connecter plusieurs bornes auxiliaires (6) pour former un circuit auxiliaire pour chacun desdits groupes et, en fonction de l'ajustement souhaité, de choisir le circuit auxiliaire aux bornes duquel la tension de claquage est appliquée.

3. Procédé d'ajustement selon la revendication 1 ou 2, **caractérisé en ce qu'**un circuit auxiliaire est formé entre une borne principale (1a, 1b) et une borne auxiliaire (6).

4. Procédé d'ajustement selon l'une quelconque des revendications 1 à 3, **caractérisé en ce qu'**un circuit auxiliaire est formé entre deux bornes auxiliaires (6).

5. Procédé d'ajustement selon l'une quelconque des revendications 1 à 4, **caractérisé en ce que** la tension de claquage étant contrôlée pour que les jonctions tunnel du circuit auxiliaire deviennent passantes.

6. Procédé d'ajustement selon l'une quelconque des revendications 1 à 5, **caractérisé en ce qu'**un groupe résistif est sélectionné en fonction de sa position dans le circuit de mesure afin d'ajuster la répartition spatiale des résistances dans ledit circuit.

7. Procédé d'ajustement selon la revendication 6, **caractérisé en ce que** le capteur comprend au moins deux blocs de mesure avec les barycentres des éléments résistifs (2) de leur circuit de mesure respectif espacés d'une distance $\lambda$, la répartition spatiale de la résistance de chacun des circuits de mesure étant ajustée afin de faire varier la distance $\lambda$.

8. Procédé d'ajustement selon l'une quelconque des revendications 1 à 7, **caractérisé en ce qu'**un groupe résistif est sélectionné en fonction de la valeur de sa résistance afin d'ajuster la valeur de la résistance du circuit de mesure.

9. Procédé d'ajustement selon la revendication 8, **caractérisé en ce qu'**un groupe résistif est sélectionné en fonction du nombre d'éléments résistifs (2) qu'il contient afin d'ajuster la valeur de sa résistance.

10. Procédé d'ajustement selon la revendication 8 ou 9, **caractérisé en ce qu'**un circuit de mesure comprend des éléments résistifs (2) dont la résistance est différente, un groupe résistif étant sélectionné en fonction du ou des élément(s) résistif(s) (2) qu'il contient afin d'ajuster la valeur de sa résistance.

11. Procédé d'ajustement selon l'une quelconque des revendications 1 à 10, **caractérisé en ce qu'**une borne auxiliaire (6) est connectée au circuit de mesure par l'intermédiaire d'un ensemble auxiliaire (7) d'éléments résistifs (2) montés en série, le circuit auxiliaire comprenant ledit ensemble.

12. Procédé d'ajustement selon la revendication 11, **caractérisé en ce que** le circuit de mesure comprend deux ensembles annexes (8) d'éléments résistifs (2) qui sont disposés de part et d'autre d'un ensemble principal (9) d'au moins un élément résistif (2), une borne auxiliaire (6) étant connectée de chaque côté dudit ensemble principal pour former avec une borne principale (1a, 1b) un circuit auxiliaire comprenant un ensemble auxiliaire (7) et un ensemble annexe (8).

**EP 2 667 214 B1**

**Patentansprüche**

1. Verfahren zum Einstellen des Widerstands eines Sensors, umfassend mindestens einen Messblock, der einen Messkreis aufweist, der zwischen zwei Hauptklemmen (1a, 1b) gebildet ist, wobei der Messkreis eine Reihenmontage von mehreren Widerstandelementen (2) umfasst, wobei das Verfahren Folgendes vorsieht:

   - Auswählen einer Widerstandsgruppe, umfassend mindestens ein Widerstandselement (2) des Messkreises;
   - Verbinden mindestens einer Hilfsklemme (6) mit dem Messkreis, wobei die Hilfsklemme derart angeordnet ist, dass sie mit einer weiteren Klemme (1a, 1b, 6) einen Hilfskreis bildet, der die Widerstandsgruppe umfasst;
   - Anwenden einer Spannung auf die Klemmen des Hilfskreises, wobei die Spannung derart gesteuert ist, dass sie den Durchbruch der Widerstandsgruppe induziert, um den Widerstand des Messkreises ohne die Widerstandsgruppe einzustellen,

   **dadurch gekennzeichnet, dass** jedes der Widerstandselemente zwei Leiterschichten umfasst, zwischen denen eine Isolierschicht angebracht ist, um eine Aufeinanderfolge von Tunnelverbindungen entlang dem Messkreise zu bilden.

2. Verfahren zum Einstellen nach Anspruch 1, **dadurch gekennzeichnet, dass** es vorsieht, mehrere Widerstandsgruppen auszuwählen, die jeweils eine Einstellung des Widerstands ermöglichen, mehrere Hilfsklemmen (6) zu verbinden, um einen Hilfskreis für jede der Gruppen zu bilden, und, in Abhängigkeit von der gewünschten Einstellung, den Hilfskreis zu wählen, an dessen Klemmen die Durchbruchsspannung angelegt wird.

3. Verfahren zum Einstellen nach Anspruch 1 oder 2, **dadurch gekennzeichnet, dass** ein Hilfskreis zwischen einer Hauptklemme (1a, 1b) und einer Hilfsklemme (6) gebildet wird.

4. Verfahren zum Einstellen nach einem der Ansprüche 1 bis 3, **dadurch gekennzeichnet, dass** ein Hilfskreis zwischen zwei Hilfsklemmen (6) gebildet wird.

5. Verfahren zum Einstellen nach einem der Ansprüche 1 bis 4, **dadurch gekennzeichnet, dass** die Durchbruchsspannung gesteuert wird, damit die Tunnelverbindungen des Hilfskreises durchgehend werden.

6. Verfahren zum Einstellen nach einem der Ansprüche 1 bis 5, **dadurch gekennzeichnet, dass** eine Widerstandsgruppe in Abhängigkeit von ihrer Position im Messkreis ausgewählt wird, um die räumliche Verteilung der Widerstände im Kreis einzustellen.

7. Verfahren zum Einstellen nach Anspruch 6, **dadurch gekennzeichnet, dass** der Sensor mindestens zwei Messblöcke umfasst, wobei die Baryzentren der Widerstandelemente (2) ihres entsprechenden Messkreises um einen Abstand $\lambda$ beabstandet sind, wobei die räumliche Verteilung des Widerstands jedes der Messkreise eingestellt ist, um den Abstand $\lambda$ variieren zu lassen.

8. Verfahren zum Einstellen nach einem der Ansprüche 1 bis 7, **dadurch gekennzeichnet, dass** eine Widerstandsgruppe in Abhängigkeit vom Wert ihres Widerstands ausgewählt wird, um den Wert des Widerstands der Messgruppe einzustellen.

9. Verfahren zum Einstellen nach Anspruch 8, **dadurch gekennzeichnet, dass** eine Widerstandsgruppe in Abhängigkeit von der Anzahl der Widerstandelemente (2) ausgewählt wird, die sie enthält, um den Wert ihres Widerstands einzustellen.

10. Verfahren zum Einstellen nach Anspruch 8 oder 9, **dadurch gekennzeichnet, dass** ein Messkreis Widerstandelemente (2) umfasst, deren Widerstand verschieden ist, wobei eine Widerstandsgruppe in Abhängigkeit von dem oder den Widerstandselement(en) (2) ausgewählt wird, die sie enthält, um den Wert ihres Widerstands einzustellen.

11. Verfahren zum Einstellen nach einem der Ansprüche 1 bis 10, **dadurch gekennzeichnet, dass** eine Hilfsklemme (6) mit dem Messkreis mit Hilfe einer Hilfseinheit (7) von Widerstandselementen (2) verbunden ist, die in Reihe montiert sind, wobei der Hilfskreis die Einheit umfasst.

12. Verfahren zum Einstellen nach Anspruch 11, **dadurch gekennzeichnet, dass** der Messkreis zwei angefügte Einheiten (8) von Widerstandselementen (2) umfasst, die auf beiden Seiten einer Haupteinheit (9) von mindestens

6

einem Widerstandelement (2) angeordnet sind, wobei eine Hilfsklemme (6) auf jeder Seite der Haupteinheit verbunden ist, um mit einer Hauptklemme (1a, 1b) einen Hilfskreis zu bilden, der eine Hilfseinheit (7) und eine angefügte Einheit (8) umfasst.

**Claims**

1. Method for adjusting the resistance of a sensor comprising at least one measurement unit, having a measurement circuit formed between two main terminals (1a, 1b), said measurement circuit comprising a series connection of several resistance elements (2), said method providing:

   - for selecting a resistance unit including at least one resistance element (2) of the measurement circuit;
   - for connecting at least one auxiliary terminal (6) to said measurement circuit, said auxiliary terminal being positioned so as to form with another terminal (1a, 1b, 6) an auxiliary circuit comprising the resistance unit;
   - for applying a voltage at the terminals of the auxiliary circuit, said voltage being controlled so as to induce the breakdown of the resistance unit in order to adjust the resistance of the measurement circuit without said resistance unit,

   **characterised in that** each resistance element comprises two conductive layers between which an insulating layer is placed to form a succession of tunnel junctions along the measurement circuit.

2. Adjustment method according to claim 1, **characterised in that** it provides for selecting several resistance units, each enabling an adjustment of the resistance, for connecting several auxiliary terminals (6) to form an auxiliary circuit for each of said units and, according to the desired adjustment, for selecting the auxiliary circuit at whose terminals the breakdown voltage is applied.

3. Adjustment method according to claim 1 or 2, **characterised in that** an auxiliary circuit is formed between a main terminal (1a, 1b) and an auxiliary terminal (6).

4. Adjustment method according to any one of claims 1 to 3, **characterised in that** an auxiliary circuit is formed between two auxiliary terminals (6).

5. Adjustment method according to any one of claims 1 to 4, **characterised in that** the breakdown voltage is controlled so that the tunnel junctions of the auxiliary circuit become conducting.

6. Adjustment method according to any one of claims 1 to 5, **characterised in that** a resistance unit is selected according to its position in the measurement circuit in order to adjust the spatial distribution of the resistors in said circuit.

7. Adjustment method according to claim 6, **characterised in that** the sensor comprises at least two measurement units with the centres of mass of the resistance elements (2) of their respective measurement circuit spaced at intervals of a distance $\lambda$, the spatial distribution of the resistor of each of the measurement circuits being adjusted in order to vary the distance $\lambda$.

8. Adjustment method according to any one of claims 1 to 7, **characterised in that** a resistance unit is selected according to the value of its resistance in order to adjust the value of the resistance of the measurement circuit.

9. Adjustment method according to claim 8, **characterised in that** a resistance unit is selected according to the number of resistance elements (2) that it contains in order to adjust the value of its resistance.

10. Adjustment method according to claim 8 or 9, **characterised in that** a measurement circuit comprises resistance elements (2) whose resistance is different, a resistance unit being selected according to the one or more resistance elements (2) that it contains in order to adjust the value of its resistance.

11. Adjustment method according to any one of claims 1 to 10, **characterised in that** an auxiliary terminal (6) is connected to the measurement circuit via an auxiliary assembly (7) of resistance elements (2) connected in series, the auxiliary circuit comprising said assembly.

**12.** Adjustment method according to claim 11, **characterised in that** the measurement circuit comprises two additional assemblies (8) of resistance elements (2) which are positioned on either side of a main assembly (9) of at least one resistance element (2), an auxiliary terminal (6) being connected on either side of said main assembly to form with a main terminal (1a, 1b), an auxiliary circuit comprising an auxiliary assembly (7) and an additional assembly (8).

Fig. 1

Fig. 2

Fig. 2a

Fig. 2b

Fig. 2c

Fig. 2d

Fig. 3a

Fig. 3b

**EP 2 667 214 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- FR 2869980
- FR 2792403
- WO 2004083881 A
- FR 2790827